# EUROPEAN PATENT APPLICATION

(11) **EP 4 635 733 A1**
(43) Date of publication of application: **22.10.2025**
(21) Application number: 23914190.6
(22) Date of filing: 09.05.2023
(51) Int. Cl.: B32B 9/00, B32B 9/04, B32B 3/22, B32B 7/12, B32B 37/12, H05K 7/20, C01B 32/194

(54) **HIGH-STRENGTH GRAPHENE HEAT-CONDUCTING PAD AND PREPARATION METHOD THEREFOR**

(30) Priority: 04.01.2023 CN 202310007425
(71) Applicant: Shenzhen HFC Co., Ltd., Shenzhen, Guangdong 518103 (CN)
(72) Inventor: CAO, Yong, Shenzhen, Guangdong 518103 (CN); YANG, Shangqiang, Shenzhen, Guangdong 518103 (CN); SUN, Aixiang, Shenzhen, Guangdong 518103 (CN); FANG, Xiao, Shenzhen, Guangdong 518103 (CN); WANG, Hongping, Shenzhen, Guangdong 518103 (CN)
(74) Representative: Bryn Aarflot AS
(86) International application number: PCT/CN2023/092920
(87) International publication number: WO 2024/146041

(57) **Abstract**

The present application relates to the field of thermal interface materials. Disclosed are a high-strength graphene heat-conducting pad and a preparation method therefore. The high-strength graphene heat-conducting pad comprises at least two graphene heat-conducting layers stacked in sequence, wherein adjacent graphene heat-conducting layers are fixedly adhered by means of an adhesive; the graphene heat-conducting layers comprise a plurality of layers of graphene films stacked in sequence; adjacent graphene films are adhered by means of an adhesive; and the stacking directions of the graphene films of two adjacent graphene heat-conducting layers are perpendicular to each other and parallel to the same plane, and the stacking directions of the graphene heat-conducting layers are perpendicular to the stacking directions of the graphene films in any graphene heat-conducting layer. In the present application, the graphene heat-conducting layers prepared by stacking the plurality of layers of graphene films are stacked, such that the stacking directions of the graphene films of adjacent layers are perpendicular to each other, thereby providing good mechanical strength in two directions in the graphene heat-conducting pad, namely, a graphene-film stacking direction and a direction perpendicular to the graphene-film stacking direction.

## Description

### Cross-Reference to Related Applications

This application claims priority to Chinese Patent Application No. 202310007425.4, filed with the China National Intellectual Property Administration on January 4, 2023, and entitled "HIGH-STRENGTH GRAPHENE HEAT-CONDUCTING PAD AND PREPARATION METHOD THEREFOR", the entire content of which is incorporated herein by reference.

### Technical Field

The present invention relates to the field of thermal interface materials, and in particular to a high-strength graphene heat-conducting pad and a preparation method therefore.

### Background Art

With the advent of the 5G era, the operating frequencies of electronic chips continue to increase, and electronic products are gradually developing towards lightweight and highly integrated designs. This trend has led to a significant rise in the heat generation of electronic devices. If excess heat is not conducted away in a timely manner, it can severely affect the performance of electronic components, and in severe cases, even lead to component failure and a shortened lifespan. To address this issue, thermal interface materials have emerged. However, traditional thermal interface materials have low thermal conductivity, typically ranging from 1 to 10 W/(m·K), making them difficult to meet the requirements of high heat conduction.

Graphene, a novel carbon material with a single-layer two-dimensional honeycomb lattice structure composed of stacked carbon atoms, not only exhibits excellent mechanical, optical, and electrical properties but also possesses superior thermal properties. Its theoretical thermal conductivity can reach 5300 W/(m·K), which is more than ten times that of common metallic materials. Currently, graphene films developed from graphene raw materials have achieved a maximum in-plane thermal conductivity of 2000 W/(m·K), demonstrating excellent heat transfer performance. These films can be applied as new thermal interface materials in chip cooling fields with high heat flux density.

Nevertheless, graphene films have poor through-plane (thickness direction) thermal conductivity, usually less than 10 W/(m·K), failing to meet the demand for vertical heat transfer. Currently, the industry primarily adopts a method of stacking graphene films to form a graphene block, which is then sliced along the stacking direction to produce a graphene heat-conducting pad with high through-plane thermal conductivity. However, due to the multi-layered structure within the graphene film, which results in poor cohesive strength, the prepared graphene heat-conducting pad exhibits anisotropy in strength. Specifically, the strength is higher in the direction perpendicular to the stacking direction of the graphene films but significantly lower in the stacking direction itself, severely limiting the practical application of the graphene heat-conducting pad. In related technologies, hole-punching equipment is used to create through-holes inside the graphene films, followed by the injection of polymer resin. However, due to the poor adhesion between graphene films and the resin, the resin easily overflows under pressure, resulting in insufficient resin filling the holes. Additionally, the hole-punching process damages the graphene films, hindering heat transfer.

### Summary of the invention

To address the above technical problems, the present application provides a high-strength graphene heat-conducting pad and a preparation method therefore, aiming to improve the thermal conductivity of the graphene heat-conducting pad while endowing it with high mechanical strength.

According to an exemplary embodiment, the present application provides a high-strength graphene heat-conducting pad by adopting the following technical solution:
A high-strength graphene heat-conducting pad, wherein the high-strength graphene heat-conducting pad may comprise at least two graphene heat-conducting layers stacked in sequence, and adjacent graphene heat-conducting layers may be fixedly adhered by means of an adhesive;
each of the graphene heat-conducting layers may comprise multiple graphene films stacked in sequence, and adjacent graphene films may be adhered by means of an adhesive;
   the stacking directions of the graphene films of two adjacent graphene heat-conducting layers may be perpendicular to each other and parallel to the same plane, and the stacking directions of the graphene heat-conducting layers are perpendicular to the stacking direction of the graphene films in any graphene heat-conducting layers.

In the above technical solution, the graphene film exhibits excellent thermal conductivity in its in-plane direction. The graphene heat-conducting layer is formed by stacking multiple graphene films, with adjacent layers adhered by means of an adhesive. This allows the high thermal conductivity of the graphene heat-conducting layer in the horizontal in-plane direction of the graphene film to be fully utilized. By adhering and stacking at least two graphene heat-conducting layers, the adhering surface of adjacent graphene heat-conducting layers is any side perpendicular to the graphene film. During stacking, the stacking directions of the graphene films in adjacent graphene heat-conducting layers are set to be perpendicular to each other. Through this method, the resulting graphene heat-conducting pad ensures that in any graphene heat-conducting layer, the stacking direction of the graphene films is perpendicular to the stacking direction of the graphene films in at least one other graphene heat-conducting layer. That is, by arranging the stacking directions of the graphene films in adjacent graphene heat-conducting layers to be perpendicular to each other, a graphene heat-conducting pad with high strength in both horizontal X and Y directions (perpendicular to each other) is prepared.

The graphene heat-conducting layer formed by stacking multiple graphene films has high strength in the direction perpendicular to the graphene film plane due to the support effect of the adhesive. However, in the stacking direction of the graphene film, the strength is low due to the poor cohesive strength of the graphene film itself. Additionally, when subjected to pressure in this direction, the adhesive between the graphene film layers is prone to overflow, affecting the mechanical properties. When stacking the graphene heat-conducting layers, by setting the stacking direction of the graphene heat-conducting layers perpendicular to the stacking direction of the graphene films, the resulting graphene heat-conducting pad exhibits good strength in both the stacking direction of the graphene films and the other two directions perpendicular to the graphene film plane.

Optionally, the graphene film is a film layer prepared by coating a graphene oxide slurry, and the specific preparation method is as follows:
S1: coating the graphene oxide slurry to obtain a graphene oxide coating film, and drying the graphene oxide coating film to obtain a graphene oxide thin film;
S2: subjecting the graphene oxide thin film to graphitization treatment to obtain the graphene film.

In the above technical solution, graphene oxide has excellent hydrophilicity and can disperse well in water to form a slurry. The graphene oxide slurry is formed into a film by a coating method. During the coating process, the graphene oxide sheets can be well oriented in the coating plane, and there is an excellent adhering effect between the graphene oxide sheets. The resulting graphene oxide film not only has high adhering force and mechanical strength but also exhibits good thermal conductivity in the plane direction of the film.

After graphitization treatment of the graphene oxide thin film, the high temperature causes the originally disordered carbon atoms in the graphene oxide to arrange orderly. The carbon material undergoes "microcrystalline" growth, transforming from a two-dimensional structure of carbon networks to a three-dimensional ordered structure. This effectively improves the mechanical properties and strength of the graphene film, significantly reduces the thermal resistance between the graphene oxide layers, and enhances the thermal conductivity in both in-plane and through-plane directions.

Optionally, in step S1, the graphene oxide slurry may be an aqueous graphene oxide slurry, with the solid content of graphene oxide being 0.1 to 15 wt%.

In the above technical solution, by defining the solid content of graphene oxide in the graphene oxide slurry within the above range, the graphene oxide slurry exhibits better coating performance, is easier to form a film, and the graphene oxide layers in the film have better orientation, thereby endowing the film with superior thermal conductivity.

Optionally, the temperature for drying the graphene oxide coating film may be 80 to 150°C.

Further preferably, the temperature for drying the graphene oxide coating film may be 100 to 120°C.

Optionally, in step S2, the graphitization temperature may be 2500 to 3200°C, and the graphitization treatment time may be 4 to 10 h.

Further preferably, the graphitization temperature may be 2800 to 3000°C.

In the above technical solution, the graphene oxide coating film is dried by heating to remove moisture therein, forming a film layer with a certain strength, which is then graphitized in a high-temperature environment. During the graphitization process, an excessively low graphitization temperature will affect the degree of graphitization, leading to insufficient graphitization inside the graphene film and thus affecting the thermal conductivity of the film layer. Conversely, an excessively high graphitization temperature will increase the brittleness of the formed graphene film, thereby deteriorating the mechanical properties of the film layer.

Optionally, the number of layers of the graphene heat-conducting layer may be an even number.

**In** the above technical solution, setting the number of layers of the graphene heat-conducting layer to an even number ensures that the mechanical properties and thermal conductivity of the graphene heat-conducting layer remain consistent in two mutually perpendicular directions, achieving balanced performance in both directions.

Optionally, the thickness of the graphene film may be 50 to 600 µm.

**In** the above technical solution, an excessively thin graphene film is not conducive to handling, as it is prone to breakage during the stacking process. Moreover, when the graphene film itself is too thin, more adhesive is required to stack it to the specified thickness, which increases the adhesive content in the graphene heat-conducting pad and thereby affects its thermal conductivity. Conversely, an excessively thick graphene film is not conducive to coating formation, and the orientation of graphene sheets within the grapheme film layer after coating is poor.

Optionally, the adhesive may be one or a combination of a polyurethane adhesive, an epoxy resin adhesive, a phenolic resin adhesive, and an acrylic resin adhesive.

**In** the above technical solution, all of the above adhesives exhibit excellent adhering effects with the graphene film while maintaining good thermal conductivity, thereby minimally impacting the thermal conductivity of the graphene heat-conducting pad.

Optionally, the coating thickness of the adhesive between the graphene film layers may be 5 to 80 µm.

Further preferably, the coating thickness of the adhesive between the graphene film layers may be 10 to 30 µm.

**In** the above technical solution, the adhesive primarily serves to fixedly adhere the graphene films. An excessively thin adhesive coating thickness may compromise the adhering effect and fail to provide adequate support when the graphene heat-conducting pad is subjected to compression, thereby affecting the mechanical strength of the pad. Conversely, an excessively thick adhesive coating increases the proportion of adhesive in the graphene heat-conducting pad, reducing the thermal conduction efficiency between the graphene film layers and consequently affecting the overall thermal conductivity of the pad.

Optionally, the thickness of the graphene heat-conducting layer may be 0.1 to 3.5 mm.

**In** the above technical solution, limiting the thickness of the graphene heat-conducting layer within the above range ensures that the graphene heat-conducting pad prepared by stacking multiple graphene layers exhibits superior thermal conductivity and mechanical strength.

According to an exemplary embodiment of the present application, a method for preparing a high-strength graphene heat-conducting pad is provided by adopting the following technical solution:
A method for preparing a high-strength graphene heat-conducting pad, the method comprising the following steps:
S1: forming a graphene block by stacking: taking a graphene film, applying an adhesive on the graphene film, placing another graphene film on the previous graphene film, and repeating this process until the stacking reaches a specified height, and curing the adhesive to obtain a graphene block;
S2: slicing the graphene block: slicing the graphene block along the stacking direction of the graphene films to obtain the graphene heat-conducting layer;
S3: stacking the graphene layers: applying an adhesive on the cut surface and/or the side parallel to the cut surface of the sliced graphene heat-conducting layer, and then stacking it with another graphene heat-conducting layer, wherein the surfaces where two adjacent graphene heat-conducting layers adhere to each other are the cut surfaces or the sides parallel to the cut surfaces, and the stacking directions of the graphene films in two adjacent graphene layers are perpendicular;
S4: curing: curing the adhesive after the graphene heat-conducting layers are stacked to a specified number of layers to obtain the high-strength graphene heat-conducting pad.

Optionally, in step S2, the slicing may be one of wire cutting, laser cutting, ultrasonic cutting, or circular knife cutting.

In the above technical solution, the graphene heat-conducting layer is prepared by first stacking multiple graphene films to form a grapheme heat-conducting block, followed by longitudinal slicing. The thickness direction of the obtained graphene heat-conducting layer corresponds to the in-plane direction of the original graphene film, thereby endowing the graphene heat-conducting layer with high thermal conductivity in its thickness direction. During the subsequent process of stacking the graphene heat-conducting layers to prepare the graphene heat-conducting pad, multiple graphene heat-conducting layers are sequentially stacked and adhesively fixed along their thickness directions. Additionally, the stacking directions of the graphene films in adjacent graphene heat-conducting layers are arranged to be perpendicular to each other. Through this arrangement, the prepared graphene heat-conducting pad exhibits high strength in both the X and Y directions, which are perpendicular to each other and lie within the plane perpendicular to the pad's thickness direction. That is, the graphene heat-conducting pad demonstrates excellent mechanical properties in the stacking direction of the graphene films in any graphene heat-conducting layer, further enhancing the mechanical properties of the graphene heat-conducting pad.

In summary, the present application includes at least one of the following beneficial technical effects.
1. In the technical solution of the present application, the graphene heat-conducting pad is prepared by stacking at least two graphene heat-conducting layers formed by stacking multiple graphene films. The stacking directions of the graphene films in adjacent heat-conducting layers are perpendicular to each other. This configuration enables the resulting graphene heat-conducting pad to exhibit excellent mechanical properties in two mutually perpendicular X and Y directions within the horizontal plane, significantly overcoming the drawback of poor mechanical properties in the stacking direction of the graphene films.
2. In the technical solution of the present application, the graphene film is prepared by coating, drying, and graphitization treatment of a graphene oxide slurry. The graphene film prepared by this method features better orientation of graphene oxide sheets in the in-plane direction, resulting in higher thermal conductivity. Additionally, the graphene film has higher internal adhering strength, contributing to superior mechanical properties.

### Brief description of drawings

Fig. 1 is a structural schematic diagram of the graphene heat-conducting pad in Example 1 of the present application.
Fig. 2 is a structural schematic diagram of the graphene heat-conducting pad in Example 2 of the present application.
Fig. 3 is a structural schematic diagram of the graphene heat-conducting pad in Example 4 of the present application.
Fig. 4 is a structural schematic diagram of the graphene heat-conducting pad in Comparative Example 1 of the present application.
Fig. 5 is a structural schematic diagram of the graphene heat-conducting pad in Comparative Example 2 of the present application.

Reference signs: 1 - Graphene film; 2 - Graphene heat-conducting layer;

### Detailed description of the invention

The following further describes the present application in detail with reference to the drawings and specific embodiments. It should be noted that, unless specifically stated, the following embodiments are carried out under conventional conditions or conditions recommended by the manufacturer; the raw materials used in the following embodiments can be obtained from ordinary commercial sources unless otherwise specified.

### Example 1

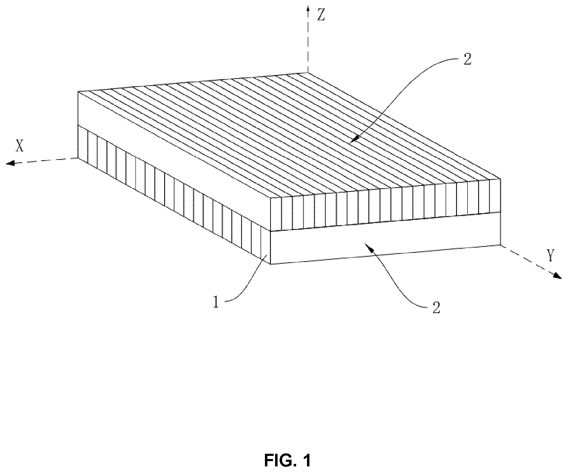

This example provides a high-strength graphene heat-conducting pad. Referring to Fig. 1, the graphene heat-conducting pad includes two graphene heat-conducting layers 2. The graphene heat-conducting layer 2 is formed by sequentially stacking multiple graphene films 1, with an adhesive coated between adjacent graphene films 1. The adhesive is an organosilicon resin adhesive, model KH-505. The graphene heat-conducting layers 2 are stacked along their thickness direction (i.e., the Z direction in the figure), and the stacking direction of the graphene heat-conducting layers 2 is perpendicular to the stacking direction of the graphene films 1. The high-strength graphene heat-conducting pad is prepared by the following method.
S1: Preparing a graphene film: taking an aqueous graphene oxide slurry with a solid content of 15 wt%, coating it with a precision coater to obtain a graphene oxide coating film with a thickness of 100 µm. Drying the graphene oxide coating film at 100°C to remove water to obtain a graphene oxide thin film, and then graphitizing the graphene oxide thin film at 2500°C for 4 h to obtain a graphene film.
S2: Forming a graphene block by stacking: taking the graphene films, uniformly coating an adhesive on one graphene film with a coating thickness of 10 µm, then stacking another graphene film on the first graphene film, repeating the stacking process in this manner. The total stacking thickness is 50 mm, and after the adhesive is cured, a graphene block is obtained. The obtained graphene block has a size of 50×50×50 mm.
S3: Slicing the graphene block: slicing the graphene block along the stacking direction of the graphene films by laser cutting, with a slicing thickness of 0.2 mm to obtain a graphene heat-conducting layer.
S4 Taking two graphene heat-conducting layers, uniformly spraying an adhesive on the cut surface with a thickness of 10 µm, then aligning and stacking the adhesive-coated sides of the two graphene heat-conducting layers, such that the stacking directions of the graphene films in the two graphene heat-conducting layers are perpendicular to each other. After the adhesive is cured, the graphene heat-conducting pad is obtained.

### Example 2

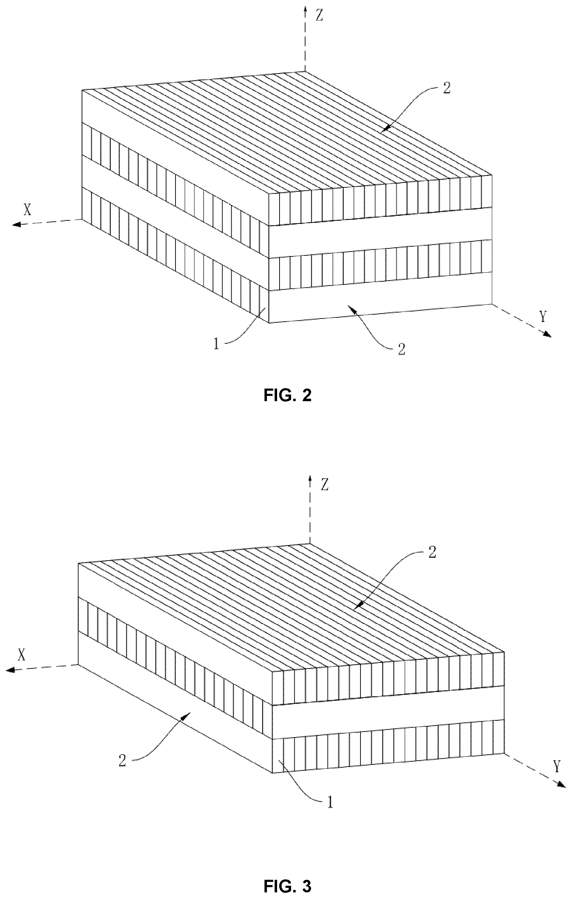

Referring to Fig. 2, a high-strength graphene heat-conducting pad. This example differs from Example 1 in that the number of graphene heat-conducting layers 2 is 4, with the rest consistent with Example 1.

### Example 3

This example differs from Example 1 in that the number of graphene heat-conducting layers is 4 and the thickness of a single-layer graphene heat-conducting layer 2 is 0.1 mm, with the rest remaining consistent with Example 1.

### Example 4

Referring to Fig. 3, this example differs from Example 3 in that the number of graphene heat-conducting layers 2 is 3, with the rest remaining consistent with Example 1.

### Comparative Example 1

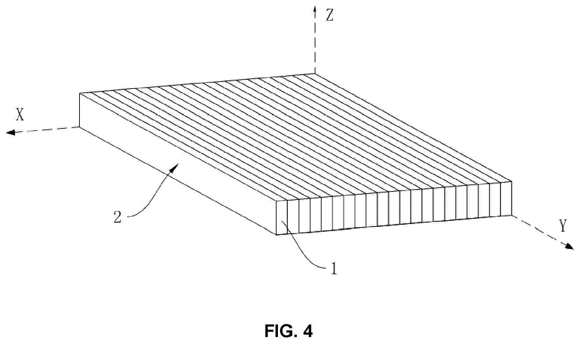

Referring to Fig. 4, this comparative example differs from Example 1 in that the graphene heat-conducting pad comprises a single graphene heat-conducting layer 2 with a thickness of 0.4 mm, and the rest remain consistent with Example 1.

### Comparative Example 2

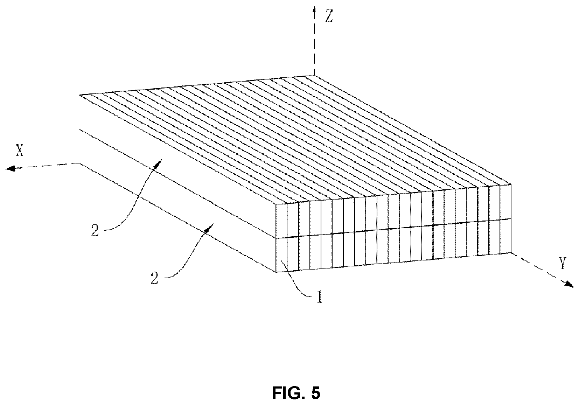

Referring to Fig. 5, this comparative example differs from Example 1 in that the stacking directions of graphene films 1 in the two graphene heat-conducting layers 2 are kept consistent, with the rest remaining identical to Example 1.

### Performance Testing

The graphene heat-conducting pads prepared in the above examples and comparative examples were subjected to thermal conductivity and mechanical property testing. The testing items are as follows.

Thermal conductivity: Testing the thermal resistance of the graphene heat-conducting pad in the thickness direction (Z direction in the figures).

Mechanical properties: Testing the tensile strength of the graphene heat-conducting pad in the horizontal directions (X and Y directions in the figures).

The performance testing results of Examples 1 to 3 and Comparative Examples 1 and 2 are shown in Table 1.

**Table 1: Performance Testing Results of Examples 1-3 and Comparative Examples 1-2.**

| | Thermal Resistance (°C·cm²/W) | Tensile Strength in X Direction (MPa) | Tensile Strength in Y Direction (MPa) |
|---|---|---|---|
| Example 1 | 0.24 | 1.04 | 1.02 |
| Example 2 | 0.22 | 1.31 | 1.34 |
| Example 3 | 0.22 | 1.24 | 1.23 |
| Example 4 | 0.21 | 1.03 | 1.26 |
| Comparative Example 1 | 0.30 | 0.02 | 1.46 |
| Comparative Example 2 | 0.33 | 0.01 | 1.37 |

According to the data in Table 1, by stacking multiple graphene heat-conducting layers and arranging the stacking directions of graphene films in adjacent layers to be perpendicular, the resulting graphene heat-conducting pad exhibits high tensile strength in both mutually perpendicular X and Y directions, without compromising its thermal conductivity. Compared with graphene heat-conducting pads made of a single graphene heat-conducting layer or those with multiple graphene films arranged in the same direction, the heat-conducting pad provided by the technical solution of this application demonstrates superior mechanical properties.

### Example 5

This example differs from Example 1 in that the solid content of graphene oxide in the graphene oxide slurry is 5 wt%, with the rest remaining consistent with Example 5.

### Example 6

This example differs from Example 5 in that the solid content of graphene oxide in the graphene oxide slurry is 20 wt%, with the rest remaining consistent with Example 5.

### Example 7

This example differs from Example 5 in that the graphene film is not subjected to graphitization treatment during the preparation process, with the rest remaining consistent with Example 5.

### Example 8

This example differs from Example 5 in that the thickness of the graphene film is 600 µm, with the rest remaining consistent with Example 5.

### Example 9

This example differs from Example 5 in that the thickness of the graphene film is 800 µm, with the rest remaining consistent with Example 5.

### Example 10

This example differs from Example 5 in that the slicing thickness of the graphene heat-conducting layer is 3.5 mm, with the rest remaining consistent with Example 5.

### Example 11

This example differs from Example 5 in that the slicing thickness of the graphene heat-conducting layer is 5 mm, with the rest remaining consistent with Example 5.

The performance testing results of Examples 5 to 11 are shown in Table 2 below.

**Table 2: Performance Testing Results of Examples 5-11.**

| | Thermal Resistance (°C·cm²/W) | Tensile Strength in X Direction (MPa) | Tensile Strength in Y Direction (MPa) |
|---|---|---|---|
| Example 5 | 0.21 | 1.34 | 1.33 |
| Example 6 | 0.25 | 1.26 | 1.23 |
| Example 7 | 0.36 | 0.89 | 0.84 |
| Example 8 | 0.18 | 1.45 | 1.47 |
| Example 9 | 0.16 | 1.25 | 1.21 |
| Example 10 | 0.21 | 1.56 | 1.55 |
| Example 11 | 0.32 | 1.41 | 1.39 |

From the data in Table 2, it can be seen that by adjusting parameters such as the thickness of the graphene film and the graphene heat-conducting layer during the preparation of the graphene heat-conducting pad, the mechanical properties and thermal conductivity of the graphene heat-conducting pad can be further improved. The data in the table also show that when parameters such as the thickness of the graphene heat-conducting layer and the graphene film are within the preferred range of this application, the prepared graphene heat-conducting pad exhibits better mechanical properties and thermal conductivity. However, when exceeding the defined range, the mechanical properties and/or thermal conductivity of the graphene heat-conducting pad decrease to a certain extent.

The above are all preferred embodiments of this application, and the protection scope of this application is not limited thereby. Thus, any equivalent variations made according to the structure, shape, and principle of this application shall be covered within the protection scope of this application.

### Industrial Applicability

The present application relates to the field of thermal interface materials. Disclosed are a high-strength graphene heat-conducting pad and a preparation method therefor. The high-strength graphene heat-conducting pad comprises at least two graphene heat-conducting layers stacked in sequence, wherein adjacent graphene heat-conducting layers are fixedly adhered by means of an adhesive; the graphene heat-conducting layers comprise a plurality of layers of graphene films stacked in sequence; adjacent graphene films are adhered by means of an adhesive; and the stacking directions of the graphene films of two adjacent graphene heat-conducting layers are perpendicular to each other and parallel to the same plane, and the stacking directions of the graphene heat-conducting layers are perpendicular to the stacking directions of the graphene films in any graphene heat-conducting layer. In the present application, the graphene heat-conducting layers prepared by stacking the plurality of layers of graphene films are stacked, such that the stacking directions of the graphene films of adjacent layers are perpendicular to each other, thereby providing good mechanical strength in two directions in the graphene heat-conducting pad, namely, a graphene-film stacking direction and a direction perpendicular to the graphene-film stacking direction.

Furthermore, it can be understood that the high-strength graphene heat-conducting pad and the preparation method of this application are reproducible and can be applied in various industrial applications. For example, the high-strength graphene heat-conducting pad of this application can be applied in the field of thermal interface material.

## Claims

1. A high-strength graphene heat-conducting pad, **characterized by** comprising at least two graphene heat-conducting layers (2) stacked in sequence, wherein adjacent graphene heat-conducting layers (2) are fixedly adhered by an adhesive;
each of the graphene heat-conducting layers (2) comprises multiple graphene films (1) stacked in sequence, and adjacent graphene films (1) are adhered by an adhesive; and
stacking directions of the graphene films (1) of two adjacent graphene heat-conducting layers (2) are perpendicular to each other and parallel to the same plane, and the stacking directions of the graphene heat-conducting layers (2) are perpendicular to a stacking direction of the graphene films (1) in any graphene heat-conducting layers (2).

2. The high-strength graphene heat-conducting pad according to claim 1, wherein the graphene film (1) is a film layer prepared by coating a graphene oxide slurry, and a preparation method is as follows:
S1: coating the graphene oxide slurry to obtain a graphene oxide coating film, and drying the graphene oxide coating film to obtain a graphene oxide thin film; and
S2: subjecting the graphene oxide thin film to graphitization treatment to obtain the graphene film (1).

3. The high-strength graphene heat-conducting pad according to claim 2, wherein in step S1, the graphene oxide slurry is an aqueous graphene oxide slurry, with a solid content of graphene oxide being 0.1 to 15 wt%.

4. The high-strength graphene heat-conducting pad according to claim 2 or 3, wherein in step S2, a graphitization temperature is 2500 to 3200 °C, and a graphitization treatment time is 4 to 10 h.

5. The high-strength graphene heat-conducting pad according to any one of claims 2 to 4, wherein in step S1, a temperature for drying the graphene oxide coating film is 80 to 150°C.

6. The high-strength graphene heat-conducting pad according to any one of claims 1 to 5, wherein a thickness of the graphene film (1) is 50 to 600 µm.

7. The high-strength graphene heat-conducting pad according to any one of claims 1 to 6, wherein the adhesive is one or a combination of a polyurethane adhesive, an epoxy resin adhesive, a phenolic resin adhesive, and an acrylic resin adhesive.

8. The high-strength graphene heat-conducting pad according to any one of claims 1 to 7, wherein the number of layers of the graphene heat-conducting layer (2) is an even number.

9. The high-strength graphene heat-conducting pad according to any one of claims 1 to 8, wherein a thickness of the graphene heat-conducting layer (2) is 0.1 to 3.5 mm.

10. The high-strength graphene heat-conducting pad according to any one of claims 1 to 9, wherein a coating thickness of the adhesive between the graphene films (1) is 5 to 80 µm.

11. A method for preparing the high-strength graphene heat-conducting pad according to any one of claims 1 to 10, **characterized in that** the method comprises following steps:
S1: forming a graphene block by stacking: taking a graphene film (1), applying an adhesive on the graphene film (1), placing another graphene film on the previous graphene film (1), and repeating this process until the stacking reaches a specified height, and curing the adhesive to obtain the graphene block;
S2: slicing the graphene block: slicing the graphene block along a stacking direction of the graphene films (1) to obtain the graphene heat-conducting layer (2);
S3: stacking the graphene heat-conducting layers: applying an adhesive on a cut surface and/or a side parallel to the cut surface of the sliced graphene heat-conducting layer (2), and then stacking the sliced graphene heat-conducting layer with another graphene heat-conducting layer (2), wherein surfaces where two adjacent graphene heat-conducting layers (2) adhere to each other are the cut surfaces or the sides parallel to the cut surfaces, and stacking directions of the graphene films in two adjacent graphene heat-conducting layers are perpendicular; and
S4: curing: curing the adhesive after the graphene heat-conducting layers (2) are stacked to a specified number of layers to obtain the high-strength graphene heat-conducting pad.

12. The method for preparing the high-strength graphene heat-conducting pad according to claim 11, wherein in step S2, the slicing is one of wire cutting, laser cutting, ultrasonic cutting, and circular knife cutting.
